# EUROPÄISCHE PATENTSCHRIFT

(11) **EP 4 131 086 B1**
(45) Veröffentlichungstag und Bekanntmachung des Hinweises auf die Patenterteilung: **25.12.2024**
(21) Anmeldenummer: 21197281.5
(22) Anmeldetag: 16.09.2021
(51) Int. Cl.: G06N 10/40, H10N 60/01, H10N 60/85, H10N 69/00

(54) **KRYO-KOMPATIBLE QUANTEN-COMPUTING-ANORDNUNG UND VERFAHREN ZUM HERSTELLEN EINER KRYO-KOMPATIBLEN QUANTEN-COMPUTING-ANORDNUNG**
CRYO-COMPATIBLE QUANTUM COMPUTATION ARRANGEMENT AND METHOD FOR PRODUCING A CRYO-COMPATIBLE QUANTUM COMPUTATION ARRANGEMENT
AGENCEMENT DE CALCUL QUANTIQUE CRYOCOMPATIBLE ET PROCÉDÉ DE FABRICATION D'UN AGENCEMENT DE CALCUL QUANTIQUE CRYOCOMPATIBLE

(30) Priorität: 03.08.2021 EP 21189507
(43) Veröffentlichungstag der Anmeldung: 08.02.2023
(60) Teilanmeldung: 24213666.1
(73) Patentinhaber: Fraunhofer-Gesellschaft zur Förderung der angewandten Forschung e.V., 80686 München (DE)
(72) Erfinder: Ramm, Peter, 80686 München (DE); Weber, Josef, 80686 München (DE); Klumpp, Armin, 80686 München (DE)
(74) Vertreter: Hersina, Günter

(56) Entgegenhaltungen:
- WO-A1-2017/015432
- WO-A1-2017/079417
- US-A1- 2018 102 469
- BALZAR D ET AL: "Tuning of Tungsten Thin Film Superconducting Transition Temperature for Fabrication of Photon Number Resolving Detectors", IEEE TRANSACTIONS ON APPLIED SUPERCONDUCTIVITY, IEEE, USA, vol. 15, no. 2, 1 June 2005 (2005-06-01), pages 3528 - 3531, XP011134449, ISSN: 1051-8223, DOI: 10.1109/TASC.2005.849033

## Beschreibung

Die vorliegende Erfindung bezieht sich auf eine kryo-kompatible Anordnung mikroelektrischer Komponenten und ein Verfahren zum Herstellen einer kryo-kompatiblen Anordnung für Quantencomputeranwendungen (quantum computing). Die kryo-kompatible Verbindung zeichnet sich dadurch aus, dass mit ihr bereits bei Zimmertemperatur (P_{T} = room temperature) oder bis etwa -70°C bzw. bei etwa -70°C die Schaltungen vorgetestet werden können (Testmodus) und beim Herunterkühlen dann im Kryo-Temperaturbereich in den supraleitenden Zustand übergehen (Betriebsmodus). Ferner bezieht sich die vorliegende Erfindung auf eine dreidimensionale, integrierte Struktur zum Ansteuern von Ionen (lonen-Qubits) in einer lonenfalle (engl. ion trap) auf einem Chip (lonenfallen-Chip, engl. ion trap chip) und eine Vorgehensweise zur kryo-kompatiblen vertikalen System-Integration von heterogenen mikroelektronischen Komponenten für Quantencomputeranwendungen.

Für den Quantencomputer bzw. das Quanten-Computing werden Ionen, bzw. lonen-Qubits oder Qubits, mit geeigneten Kontroll-/Auslesesystemen (engl. control/readout-systems) unter dem Einsatz von Verdrahtungsverfahren integriert. Für die benötigten kryo-kompatiblen Integrationsmethoden bzw. integrierten Strukturen werden nach dem Stand der Technik Lotverbindungen eingesetzt, da sie eine Niedertemperaturprozessierung ohne Degradierung von Qubits, zum Beispiel supraleitende Transmons (Typ von supraleitendem Ladungsqubit) auf der Basis von Josephson Junctions (Übergängen), ermöglichen. Diese herkömmlich eingesetzten Lote erfüllen jedoch nicht die Anforderung an eine hohe Eingabe-Ausgabe-Anzahl (engl. I/O counts) und der hohen Verdrahtungsdichten bei gleichzeitig minimalen Abständen (engl. stand-off distance). So liegt zukünftig ein Fokus auf einer Skalierung bzw. Skalierbarkeit (engl. scaling) der Quanten-Computing-Komponenten.

Die WO 2017/015432 A1 bezieht sich auf eine supraleitende integrierte Schaltung. Die Schaltung umfasst mindestens einen supraleitenden Resonator, einschließlich eines Substrats, einer leitfähigen Schicht, die über eine Oberfläche des Substrats angeordnet ist, wobei die leitfähige Schicht mindestens ein leitfähiges Material umfasst, das ein im Wesentlichen spannungsarmes polykristallines Titannitrid (TiN)-Material aufweist.

Die WO 2017/070417 A1 bezieht sich auf Verbindungsstrukturen zum Aufbau von Halbleiterstrukturen, die supraleitende integrierte Schaltungen umfassen. Eine mehrschichtige Halbleiterstruktur umfasst eine erste Halbleiterstruktur und eine zweite Halbleiterstruktur, wobei zumindest eine der ersten und zweiten Halbleiterstrukturen als eine supraleitende Halbleiterstruktur vorgesehen ist. Die mehrschichtige Halbleiterstruktur umfasst ferner eine oder mehrere Verbindungsstrukturen. Jede der Verbindungsstrukturen ist zwischen der ersten und zweiten Halbleiterstruktur angeordnet und mit jeweiligen Verbindungsanschlussflächen, die auf der ersten und zweiten Halbleiterstruktur vorgesehen sind, gekoppelt. Zusätzlich umfasst jede der Verbindungsstrukturen eine Mehrzahl von Verbindungsabschnitten. Zumindest einer der Verbindungsabschnitte umfasst entweder ein supraleitendes oder teilweise supraleitendes Material.

Die US 2018/102469 A1 bezieht sich auf eine CSP-Struktur (CSP = Chip Scale Packaging) für eine lichtemittierende Diode und auf ein Modul mit direkter Hintergrundbeleuchtung.

Die XP 011 134 449 bezieht sich auf die Abstimmung der Wolframdünnfilm-Supraleitungsübergangstemperatur für die Herstellung von Photonenanzahl-auflösenden Detektoren.

Es besteht somit ein Bedarf nach einer kryo-kompatiblen Quanten-Computing-Anordnung, die eine möglichst unaufwändig zu implementierende, einfach zu testende und (i.W. beliebig) skalierbare Kontaktierungsanordnung aufweist, und nach einem entsprechenden Herstellungsverfahren für eine solche kryo-kompatible Quanten-Computing-Anordnung.

Dieser Bedarf wird durch den Gegenstand der unabhängigen Patentansprüche 1 und 13 erfüllt.

Vorteilhafte Ausgestaltungen und Weiterbildungen der vorliegenden Anmeldung sind Gegenstand der abhängigen Patentansprüche.

### Zusammenfassung der Erfindung

Ein Kerngedanke von Ausführungsbeispielen der vorliegenden Erfindung besteht darin, eine kryo-kompatible Quanten-Computing-Anordnung bereitzustellen, bei der die Zwischenverbindungen (engl. interconnects) und/oder Durchführungen, z. B. TSVs, der vertikal integrierten Anordnung von heterogenen mikroelektronischen Komponenten jeweils zwischen einem ersten und einem zweiten Kontaktelement ein Schichtelement mit einem ersten Material aufweist, das bei einer Quantencomputer-Betriebstemperatur supraleitend ist, und ein Füllelement mit einem zweiten Material aufweist, das elektrisch leitend ist. Dies trifft auf einige metallische Verbindungen zu, solange aber die Temperatur niedrig genug ist (z.B. im mK-Bereich). Es gibt allerdings Kristallmodifikationen, welche bereits bei höheren Temperaturen in den supraleitenden Zustand übergehen. Dies ist zum Beispiel bei der β-Wolfram-Modifikation der Fall. Um dabei die β-Modifikation von Wolfram zu nutzen, weist die integrierte Verdrahtung in den TSVs beispielsweise eine Schichtstruktur z.B. mit Titannitrid und Wolfram auf. Titannitrid selbst wird bei niedrigen Temperaturen ebenfalls supraleitend (ca. 1,6 K).

Gemäß einem Ausführungsbeispiel füllt das Füllelement zumindest 50 % (oder zumindest 70, 90 oder 99%) des jeweiligen Volumens der leitfähigen Durchführungen entlang des Querschnitts zwischen dem ersten und zweiten Hauptoberflächenbereich der Substratstruktur. Das Füllelement kann das jeweilige Volumen (= Restvolumen der mit dem Schichtelement versehenen Durchführungen) auch vollständig füllen.

Gemäß dem erfindungsgemäßen Ansatz werden aber durch den Einsatz der Kombination einer integrierten Verdrahtung die mikroelektrischen Komponenten für die Quantencomputeranwendungen mit Hilfe einer 3D-TSV-Technologie (TSV = engl. Through Silicon Via) angesteuert, wobei die leitfähigen TSV-Durchführungen zumindest teilweise oder vollständig mit einer Schichtstruktur aus elektrisch leitendem Material und ferner einem bei Quantencomputer-Betriebstemperatur supraleitenden Material gefüllt sind. Um dabei die β-Modifikation von Wolfram zu nutzen, weist die integrierte Verdrahtung in den TSVs beispielsweise die Schichtstruktur z.B. mit einem supraleitendem Material, wie z.B. Titannitrid (oder mit einem anderen supraleitenden Material) und einem elektrisch leitenden Material, wie z.B. Wolfram bzw. einem Wolfram-basierten Material (oder mit einem anderen elektrisch leitenden Material), auf.

Ein Ausführungsbeispiel gemäß der vorliegenden Erfindung umfasst eine kryo-kompatible Quanten-Computing-Anordnung, beispielsweise eine dreidimensionale Struktur zum Ansteuern von lon-Trap-Qubits in einem lon-Trap-Chip, zum Beispiel für einen Betrieb im Kryo-Temperaturbereich, mit einer mikroelektrischen Quanten-Computing-Komponente und einer weiteren mikroelektrischen Komponente. Die mikroelektrische Quanten-Computing-Komponente umfasst eine Substratstruktur, beispielsweise aus Silizium und/oder Siliziumdioxid, mit einer Mehrzahl von ersten Kontaktelementen und einer Mehrzahl von leitfähigen Durchführungen, beispielsweise Through Silicon Vias (TSVs), durch die Substratstruktur.

Gemäß eines Ausführungsbeispiels der vorliegenden Erfindung füllt das Füllelement die leitfähigen Durchführungen jeweils zumindest teilweise oder auch vollständig mit einem elektrisch leitfähigen Material, wie z.B. Wolfram, aus. Beispielsweise kann das Füllelement auch eine elektrisch leitfähiges Material wie Niob (Ni), Tantal (Ta), Titannitrid (TiN), Platin (Pt), Palladium (Pd), Nickel (Ni), Kupfer (Cu), Aluminium (Al), Titan (Ti) oder Blei (Pb) oder eine elektrisch leitende Legierung aufweisen.

Indem die leitfähigen Durchführungen (TSVs) zumindest teilweise oder auch vollständig (bis auf das supraleitende Schichtelement) mit dem elektrisch leitfähigen Füllelement, wie z.B. mit Wolfram, gefüllt sind, kann eine hohe Leitfähigkeit der TSVs bereits bei relativ hohen Temperaturen (im Kryo-Temperaturbereich) über dem Sprungpunkt der Supraleitfähigkeit bereitgestellt werden, im Vergleich beispielsweise zu Titannitrid-metallisierten TSVs. Dadurch kann eine relativ einfache Testbarkeit der mikroelektronischen Komponenten erreicht und die Funktionalität derselben überprüft werden noch bevor die mikroelektronischen Komponenten bei den Anwendungstemperaturen unterhalb der Sprungtemperatur für die Supraleitfähigkeit eingesetzt werden. Aufgrund der hohen Leitfähigkeit der mit Wolfram gefüllten Durchführungen (TSVs) kann ein zuverlässiger Funktionstest bereits in einem Temperaturbereich um 70°K (Stickstofftemperatur) durchgeführt werden, d.h. unterhalb dem Siedepunkt von Stickstoff bei 77,4 K (-195,8 °C).

Die beispielsweise zumindest teilweise gefüllten TSVs können im Querschnitt zumindest zu 20 %, zu 50 %, zu 70 % oder zu 90 % oder auch vollständig mit dem elektrisch leitfähigen Material, wie z.B. Wolfram, gefüllt sein. Je größer der Füllungsgrad der TSVs mit Wolfram ist, umso höher ist die Leitfähigkeit der TSVs bei Temperaturen über dem Sprungpunkt der Supraleitfähigkeit.

Im Allgemeinen deckt die Kryotechnik beispielsweise den Temperaturbereich von unterhalb -150 °C ab. Technisch zugänglich sind Temperaturen entsprechend von unterhalb 77,4 K (-195,8 °C), dem Siedepunkt von Stickstoff, 20,4 K (zum Beispiel mittels Wasserstoff), und 4,2 K (zum Beispiel mittels Helium). Tiefere Temperaturen im kryogenen Temperaturbereich sind beispielsweise durch Druckverminderung und die damit verbundene Änderung der Siedepunkte erreichbar. Darüber hinaus ist es möglich, mittels Helium eine Temperatur von ca. 1 K zu erreichen. Um entsprechend tiefere Temperaturen, beispielsweise ca. 1 mK erreichen zu können, wird ein vergleichsweise teures Isotop 3He oder ein Helium-Gemisch verwendet. Aufgrund der Tatsache, dass Kupfer in keinem Temperaturbereich supraleitfähig wird, sind die leitfähigen Durchführungen (TSVs) mit dem Schichtelement, das bei einer Quantencomputer-Betriebstemperatur supraleitend ist, und mit dem Füllelement, das elektrisch leitend ist gefüllt, so dass eine entsprechend hohe elektrische Leitfähigkeit sowohl innerhalb der kryogenen Temperaturbereiche als auch außerhalb der kryogenen Temperaturbereiche bereitgestellt werden kann.

Das Schichtelement kann beispielsweise eines oder mehrere der folgenden Materialien aufweisen: Wolfram, Technetium, Tantal, Niob, Nb₃Ge, MoN, MgB₂, K₃C₆₀, Gallium, Blei, AuPb, Aluminium, (und folgende metallischen Nitride) TiN, ZrN, HfN, VN, NbN, TaN, MoN, WN. Davon weist NbN die höchste Sprungtemperatur mit *T*_{C} ~ 17K auf, während TiN eine Sprungtemperatur *T*_{C} ~ 4.8K aufweist.

Der Testmodus der Quanten-Computing-Anordnung umfasst beispielsweise einen Temperaturbereich bei Zimmertemperatur von z.B. 295,15 K (bei 22°C) bis z.B. 203,15 K (-70°C). Der Kühlmodus der Quanten-Computing-Anordnung umfasst beispielsweise einen Temperaturbereich von den entsprechend 203,15 K (-70°C) bis zu entsprechend 10 K (-263,15°C). In anderen Worten wird während des Kühlmodus die Temperatur der Quanten-Computing-Anordnung von Zimmertemperatur bzw. der Temperatur des Testmodus auf Betriebstemperatur, entsprechend dem Betriebsmodus der Quanten-Computing-Anordnung heruntergekühlt. Der Betriebsmodus umfasst beispielsweise einen Temperaturbereich unterhalb 10 K bzw. beginnend oder teilweise überlappend ab 10 K (-263,15°C) bis z.B. 0,001 K (-273,149°C).

Zusammengefasst wird also der Testmodus der Kryo-kompatiblen Quanten-Computing-Anordnung in einem relativ unaufwändig einzustellenden Temperaturbereich durchgeführt, wobei dort die hohe elektrische Leitfähigkeit des Füllmaterials der leitfähigen Durchführungen genutzt wird, während der Betriebsmodus im Kryo-Temperaturbereich erfolgt, wobei dort die Supra-leitfähigkeit des Schichtelements der leitfähigen Durchführungen genutzt wird.

Gemäß der vorliegenden Erfindung weist kann das Schichtelement eine Beta-Modifikation von Wolfram auf, wobei das Füllelement ein Wolfram-Material aufweisen kann. Wolfram wird bei einer Temperatur von etwa 0,015 K (15 mK) und darunter supraleitend, während die Beta-Wolfram-Modifikation bereits bei einer Temperatur von etwa 4 K und darunter supraleitend wird. Titannitrid selbst wird bei niedrigen Temperaturen ebenfalls supraleitend (ca. 1,6 K). Ferner kann zusätzlich das Schichtelement ein Niob Material, ein Titannitrid Material und ein Tantal Material umfassen. Die Supraleitfähigkeit der genannten Materialien wird somit im Betriebsmodus der Quanten-Computing-Anordnung erreicht.

Um die β-Modifikation von Wolfram bei der Herstellung zu erhalten, werden TSVs mit einem Schichtstapel gefüllt, der das Wolfram dauerhaft unter Druckspannung setzt. Beispielsweise kann zur Erhaltung der Beta-Modifikation des Wolframs des Schichtelements das Wolfram als eine Schicht in den leitfähigen Durchführungen des Substrats angeordnet sein, wobei angrenzend an das Schichtelement des Beta-Wolfram-Materials beispielsweise eine weitere Schicht eines weiteren Materials angeordnet sein, das einen höheren Wärmeausdehnungskoeffizienten als das Wolfram-Material aufweist. Dies ist beispielsweise bei der Verwendung von Wolfram mit einer angrenzenden Titannitrid-Schicht (als die weitere Schicht) oder zwischen Titannitrid-Schichten (als die weiteren Schichten) der Fall.

Gemäß einem weiteren Ausführungsbeispiel ausserhalb der Erfindung kann der Schichtstapel auch Niob (als Schichtelement) mit einer angrenzenden Titannitrid-Schicht (als die weitere Schicht) aufweisen oder zwischen Titannitrid-Schichten (als die weiteren Schichten) angeordnet sein oder Tantal (als Schichtelement) mit einer angrenzenden Titannitrid-Schicht (als die weitere Schicht) aufweisen oder zwischen Titannitrid-Schichten (als die weiteren Schichten) angeordnet sein. Beispielsweise kann die weitere Schicht bzw. die weiteren Schichten neben (= anstelle von) Titannitrid (TiN) auch Wolframdisulfid (WS2), Platin (Pt), Palladium (Pd), Nickel (Ni), Aluminium (Al) und/oder Aluminiumoxid (Al2O3) aufweisen. Dabei können die Schichtdicken des Schichtstapels und des Füllelements das Durchgangsloch zumindest teilweise füllen und zusammengenommen dem Querschnitt des Durchgangslochs entsprechen. Unter Verwendung des erfindungsgemäßen Verfahrens, das im weiteren Verlauf der Beschreibung ausgeführt wird, kann beispielsweise sowohl der vorhin erwähnte Schichtstapel als auch das Wolfram in das Durchgangsloch abgeschieden werden.

Die leitfähigen Durchführungen (TSVs) sind an einem ersten Hauptoberflächenbereich der Substratstruktur mit zugeordneten ersten Kontaktelementen der mikroelektrischen Quanten-Computing-Komponente elektrisch verbunden. Zum Beispiel ist jede einzelne Durchführung der mikroelektrischen Quanten-Computing-Komponente jeweils einem ersten Kontaktelement zugeordnet. In anderen Worten kann jede einzelne leitfähige Durchführung an der ersten Hauptoberfläche der Substratstruktur mit einem ersten Kontaktelement zugeordnet und elektrisch verbunden sein. Die weitere mikroelektrische Komponente umfasst eine Mehrzahl von zweiten Kontaktelementen, die mit den leitfähigen Durchführungen (TSVs) an einem zweiten Hauptoberflächenbereich der Substratstruktur der mikroelektrischen Quanten-Computing-Komponente zugeordnet und elektrisch verbunden sind. Somit wird ein elektrische Verbindung von den ersten Kontaktelementen der mikroelektronischen Quanten-Computing-Komponente zu den zweiten Kontaktelementen der weiteren mikroelektrischen Komponente bereitgestellt.

Gemäß einem weiteren Ausführungsbeispiel sind die Kontaktelemente als Bond-Bumps bzw. Bond-Pillars ausgebildet. In anderen Worten können die Kontaktelemente, die als elektrische Verbindung zwischen der mikroelektrischen Quanten-Computing-Komponente und der weiteren mikroelektrischen Komponente dienen, beispielsweise eine entsprechend kugelförmige oder säulenförmige Form und eine eckige (z. B. rechteckige), runde (z. B. kreisrunde) und/oder elliptische Querschnittsform aufweisen, wobei diese Aufzählung nicht als abschließend anzusehen ist. Darüber hinaus ist es möglich, je nach Anforderung, die elektrische Verbindung als Erhöhung (engl. bump) auszuformen und beispielsweise mittels Adhäsion zu erhalten, etwa indem eine klebendes Material zwischen den Kontaktelementen und der mikroelektrischen Komponente aufgetragen werden kann.

Gemäß einem weiteren Ausführungsbeispiel kann die Kontaktverbindung, zum Beispiel die elektrische Verbindung der leitfähigen Durchführungen, zwischen den Kontaktelementen der mikroelektrischen Quanten-Computing-Komponente eine kryo-kompatible interdiffusionsmetallische Verbindung aufweisen.

Gemäß einem weiteren Ausführungsbeispiel weisen die Kontaktelemente an dem zweiten Hauptoberflächenbereich der Substratstruktur mit den Kontaktelementen der weiteren mikroelektrischen Komponente interdiffusionsmetallische Verbindungen auf. Dadurch, dass an dem ersten Hauptoberflächenbereich der Substratstruktur und an dem zweiten Hauptoberflächenbereich der Substratstruktur kryo-kompatible interdiffusionsmetallische Verbindungen zwischen den TSVs und den entsprechend zugeordneten ersten Kontaktelementen und/oder zweiten Kontaktelementen aufweisen, kann eine entsprechend stabile elektrische Verbindung bereitgestellt werden, so dass aus kryo-kompatiblen Materialien die Supraleitfähigkeit bei den Anwendungstemperaturen des Quanten-Computings, zum Beispiel im Bereich von 10-1000 mK, realisiert werden kann.

Ausführungsbeispiele schaffen eine Anordnung in der die Kontaktelemente der mikroelektronischen Quanten-Computing-Komponente mit einer Mehrzahl von TSVs in einer Parallelschaltung, zum Beispiel zur Widerstandsverringerung verbunden sind. Indem beispielsweise zumindest ein Teil der Anordnung parallel geschaltet wird, kann ein resultierender Widerstandswert (Leitwert) eingestellt werden, d.h. durch eine definierte Anzahl von parallelgeschalteten TSV kann, je nach Anwendung der resultierende Widerstandswert eingestellt bzw. entsprechend verringert werden.

Gemäß einem weiteren Ausführungsbeispiel ist die Mehrzahl von leitfähigen Durchführungen (TSVs) mittels eines Isolationsmaterials, beispielsweise an den Seitenwänden der Durchführungen von der Substratstruktur elektrisch isoliert, etwa indem ein dielektrisches Material, beispielsweise ein Dielektrikum, zwischen der Substratstruktur und dem TSV angeordnet ist. So kann beispielsweise das Isolationsmaterial und gegebenenfalls auch das Wolfram-basierende Schichtfolge unter Verwendung des erfindungsgemäßen Herstellungsverfahrens an die Seitenwände der TSVs abgeschieden werden, so dass beispielsweise eine interdiffusionsmetallische Verbindung entstehen kann.

Ein weiteres Ausführungsbeispiel gemäß der vorliegenden Erfindung umfasst leitfähige Durchführungen (TSVs), die einen Durchmesser im Bereich von 0,8 µm bis 1,5 µm aufweisen. Ferner können die TSVs einen minimalen TSV-Abstand zueinander aufweisen, der einen Bereich von 1,6 µm bis 3 µm umfasst. Beispielsweise kann die TSV-Tiefe in das Substrat mindestens 6 µm bis 10 µm aufweisen. Ferner kann die leitfähige Durchführung ein Seitenverhältnis von 10:1 bis 20:1 aufweisen, um eine möglichst hohe Integrationsdichte in dem Substrat zu erreichen, so dass die hohe Verdrahtungsdichte eine hohe Anzahl der Qubits ansteuern kann.

Ein Ausführungsbeispiel gemäß der vorliegenden Erfindung umfasst ferner ein Verfahren zum Herstellen einer kryo-kompatiblen Quanten-Computing-Anordnung, beispielsweise für den Betrieb im Kryo-Temperaturbereich. Beispielsweise umfasst das Verfahren ein Bereitstellen der Substratstruktur mit einer Mehrzahl von ersten Kontaktelementen. Ferner umfasst das Verfahren ein Formen von leitfähigen Durchführungen (TSVs), beispielsweise unter Verwendung des Bosch-Ätzen, des DRIE oder eines Nassätzen-Prozesses. Ferner kann das Verfahren ein Aufbringen einer Isolationsschicht bzw. eines Isolationsmaterials beispielsweise an den Seitenwänden der Durchführungen aufweisen. Beispielsweise kann das Isoliermaterial Siliziumdioxid umfassen und unter Verwendung der Plasma-unterstützten chemischen Gasphasenabscheidung (PECVD) an den Seitenwänden der leitfähigen Durchführungen aufgebracht werden. Ferner kann das Verfahren ein Füllen aufweisen, indem unter Verwendung des chemischen Gasphasenabscheidungsprozesses (PVD) die TSVs mit Wolfram Material in das leitfähige Durchgangsloch gefüllt beziehungsweise aufgetragen werden. Ferner kann das Verfahren ein chemisch-mechanisches Polieren (CMP) umfassen, das Unreinheiten auf der mikroelektrischen Quanten-Computing-Komponente beseitigen soll. Ferner umfasst das Verfahren ein Kontaktieren der ersten Kontaktelemente mit dem mit Wolfram Material gefüllten Kontaktloch und der Mehrzahl von zweiten Kontaktelementen, so dass eine dreidimensionale Struktur zum Ansteuern von lon-Trap-Qubits für einen Betrieb im Kryo-Temperaturbereich bereitgestellt werden kann.

Beispielsweise kann unter Verwendung des Verfahrens eine kryo-kompatiblen intermetallischen Bondverbindung mit hoher Integrationsdichte der TSVs, basierend auf Metall-Interdiffusionsverfahren und/oder basierend auf Fest-Flüssig-Diffusionsverfahren (engl. solid-liquid diffusion, SLID) bereitgestellt werden, so dass die Anzahl der angesteuerten lon-Trap-Qubits, beispielsweise um mehr als zwei Größenordnungen gesteigert werden kann. Vorteilhafterweise ist der Einsatz des Verfahrens exzellent geeignet für das bei den Quanten-Computern geforderte Scaling.

Ferner ermöglichen es Ausführungsbeispiele, dass das Verfahren unter Verwendung eines Metall-Interdiffusionsverfahrens, zum Beispiel auf Basis des Metall-Systems Nb/TiN/Au, eine gemeinsame Schicht zweier verschiedenartiger Atomsorten aus ehemals getrennten Bereichen ineinander hergestellt bzw. erreicht werden. Beispielsweise können sich die Atome des ersten Kontaktelements und die Atome des Wolfram Materials mittels Diffusion verbinden, um Konzentrationsunterschiede in den Materialien auszugleichen. Hierdurch wurde erkannt, dass sich die Integrationsdichte in der Substratstruktur steigern lässt, so dass die Anzahl der angesteuerten lonen-Trap-Qubits um mehr als zwei Größenordnungen gesteigert werden konnte. Daher ist das Verfahren exzellent geeignet für das bei den Quanten Computing geforderte Scaling im kryogenen Temperaturbereich.

Ausführungsbeispiele schaffen eine kryo-kompatible Quanten-Computing-Anordnung in der das Schichtelement ein unter Druckspannung stehende Beta-Modifikation von Wolfram aufweist. Wolfram Schichten weisen sowohl die stabile kubisch raumzentrierte α-Phase wie auch die metastabile β-Phase auf.

Ausführungsbeispiele schaffen eine kryo-kompatible Quaten-Computer-Anordnung, in der angrenzend an das Schichtelement mit der Beta-Modifikation des Wolfram-Materials eine weitere Schicht mit einem weiteren Material angeordnet ist, das einen höheren Wärmeausdehnungskoeffizienten als das Wolfram-Material aufweist. Damit weist das Wolfram auch noch bei größeren Schichtdicken noch die Beta-Modifikation auf.

Ausführungsbeispiele schaffen eine kryo-kompatible Quaten-Computer-Anordnung, in der angrenzend an das Schichtelement mit der Beta-Modifikation des Wolfram-Materials jeweils beidseitig eine weitere Schicht mit einem weiteren Material angeordnet ist, das jeweils einen höheren Wärmeausdehnungskoeffizienten als das Wolfram-Material aufweist. Damit weist das Wolfram auch noch bei größeren Schichtdicken noch die Beta-Modifikation auf.

Um die hohe Sprungtemperatur des Wolframs zu erzielen, ist es vorteilhaft, wenn das abgeschiedene Wolfram, beispielsweise während des Kühlungsprozess für den kryogenen Temperaurbereich der Quanten Computing Anwendung, stets unter einer entsprechenden Druckspannung verbleibt. Hierdurch wird die metastabile β-Phase des Wolframs aufrechterhalten, beziehungsweise stabilisiert, welches eine höhere Sprungtemperatur aufweist als andere Wolfram-Phasen, beispielsweise die stabile kubisch raumzentrierte α-Phase. Vorzugsweise kann die Wolfram-Schicht (Beta-Wolfram-Schicht) zwischen Materialien eingebettet sein, die einen höheren Wärmeausdehnungskoeffizienten als Wolfram aufweisen, wie beispielsweise Titannitrid (TiN), Wolframdisulfid (WS₂), Platin (Pt), Palladium (Pd), Nickel (Ni), Aluminium (Al) und/oder Aluminiumoxid (Al₂O₃).

Gemäß einem weiteren Ausführungsbeispiel der vorliegenden Erfindung kann das Verfahren im Fertigungsprozess während der Front-End-of-Line-Prozesse (FEOL) oder auch während der Back-End-of-Line-Prozesse (BEOL) durchgeführt werden. Beispielsweise kann das Kontaktieren im FEOL stattfinden, unter Verwendung des Fest-Flüssig-Interdiffusions-Löten (Solid-Liquid-Interdiffusion Soldering, SLID) stattfinden.

Das Verfahren basiert auf denselben Überlegungen wie die oben beschriebene Vorrichtung und kann optional um alle Merkmale, Funktionalitäten und Details ergänzt werden, die hierin auch im Hinblick auf die erfindungsgemäße Vorrichtung beschrieben sind. Das Verfahren kann um die genannten Merkmale, Funktionalitäten und Details sowohl einzeln auch in Kombination ergänzt werden.

Insofern liefert das Erfindungskonzept mit relativ geringem Aufwand eine kryo-kompatible Quanten-Computing-Anordnung, die einen verbesserten Kompromiss zwischen Scaling, Temperaturbereich der Supraleitfähigkeit und Implementierungsaufwand beinhaltet. Darüber hinaus kann der Aufwand (und die daraus resultierenden Kosten) beim Testen aufgrund der Tiefkälteumgebung gering gehalten werden.

### Kurzbeschreibung der Figuren

Ausführungsbeispiele werden nachfolgend bezugnehmend auf die beiliegenden Zeichnungen erläutert. Es zeigen:
- Fig. 1A: eine schematische Schnittansicht einer kryo-kompatiblen Quanten-Computing-Anordnung gemäß einem Ausführungsbeispiel;
- Fig. 1B: eine schematische Schnittdarstellung der leitfähigen Durchführung der kryo-kompatiblen Quanten-Computing-Anordnung mit einem Schichtelement und einem Füllelement gemäß einem Ausführungsbeispiel;
- Fig. 2: eine schematische Schnittdarstellung einer leitfähigen Durchführung mit einem Isolationsmaterial und einem Wolfram Material gemäß einem Ausführungsbeispiel;
- Fig. 3: eine schematische Schnittdarstellung einer leitfähigen Durchführung mit jeweils einem Schichtstapel an den Seitenwänden gemäß einem Ausführungsbeispiel;
- Fig. 4: eine schematische Schnittdarstellung einer leitfähigen Durchführung mit zueinander verbundenen Schichtstapeln gemäß einem Ausführungsbeispiel;
- Fig. 5: eine schematische Schnittdarstellung einer leitfähigen Durchführung mit einer weiteren Ausführung eines Schichtstapels gemäß einem Ausführungsbeispiel, und
- Fig.6: ein beispielhaftes prinzipielles Ablaufdiagramm des erfindungsgemäßen Herstellungsverfahrens gemäß einem Ausführungsbeispiel.

### Detaillierte Beschreibung von Ausführungsbeispielen der Erfindung

Bevor nachfolgende Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Nachfolgend beschriebene Ausführungsbeispiele werden im Zusammenhang mit einer Vielzahl von Details beschrieben. Ausführungsbeispiele können jedoch auch ohne diese detaillierten Merkmale limitiert werden. Des Weiteren werden Ausführungsbeispiele der Verständlichkeit wegen unter Verwendung von Schnittdarstellungen als Ersatz einer detaillierten Darstellung beschrieben. Ferner können Details und/oder Merkmale einzelner Ausführungsbeispiele ohne Weiteres miteinander kombiniert werden, solange es nicht explizit gegenteilig beschrieben ist.

Es versteht sich, dass, wenn ein Element als mit einem anderen Element "verbunden" oder "gekoppelt" bezeichnet wird, es direkt mit dem anderen Element verbunden oder gekoppelt sein kann oder Zwischenelemente vorhanden sein können. Wenn im Gegensatz ein Element als "direkt" mit einem anderen Element "verbunden" oder "gekoppelt" bezeichnet wird, sind keine Zwischenelemente vorhanden. Sonstige zum Beschreiben des Verhältnisses zwischen Elementen benutzten Ausdrücke sollten auf gleichartige Weise ausgelegt werden (z. B. "zwischen" gegenüber "direkt zwischen", "benachbart" gegenüber "direkt benachbart" usw.).

Im Rahmen der vorlegenden Beschreibung weisen Elemente aus einem bestimmten Material oder einer bestimmten Materialkombination zumindest zu 90%, 95% oder 99% oder auch vollständig das angegebene Material oder die angegebene Materialkombination auf. Somit können die angegebenen Materialien auch in dem angegebenen geringen Umfang einen weiteren Bestandteil oder weitere Bestandteile (Materialien) aufweisen. Dies kann beispielsweise aufgrund von Aufbringungsprozessen, etc. erfolgen.

Zur Vereinfachung der Beschreibung der unterschiedlichen Ausführungsbeispiele weisen die Figuren ein kartesisches Koordinatensystem x, y, z auf, wobei die Richtungen x, y, z orthogonal zueinander angeordnet sind. Bei den Ausführungsbeispielen entspricht die x-y-Ebene dem Hauptoberflächenbereich eines Trägers bzw. Substrats (= Referenzebene = x-y-Ebene), wobei die dazu vertikale Richtung nach oben bezüglich der Referenzebene (x-y-Ebene) der "+z"-Richtung entspricht, und wobei die Richtung vertikal nach unten bezüglich der Referenzebene (x-y-Ebene) der "-z"-Richtung entspricht. In der folgenden Beschreibung bedeutet der Ausdruck "lateral" eine Richtung parallel zu der x- und/oder y-Richtung, d. h. parallel zu der x-y-Ebene, wobei der Ausdruck "vertikal" eine Richtung parallel zu der +/- z-Richtung angibt.

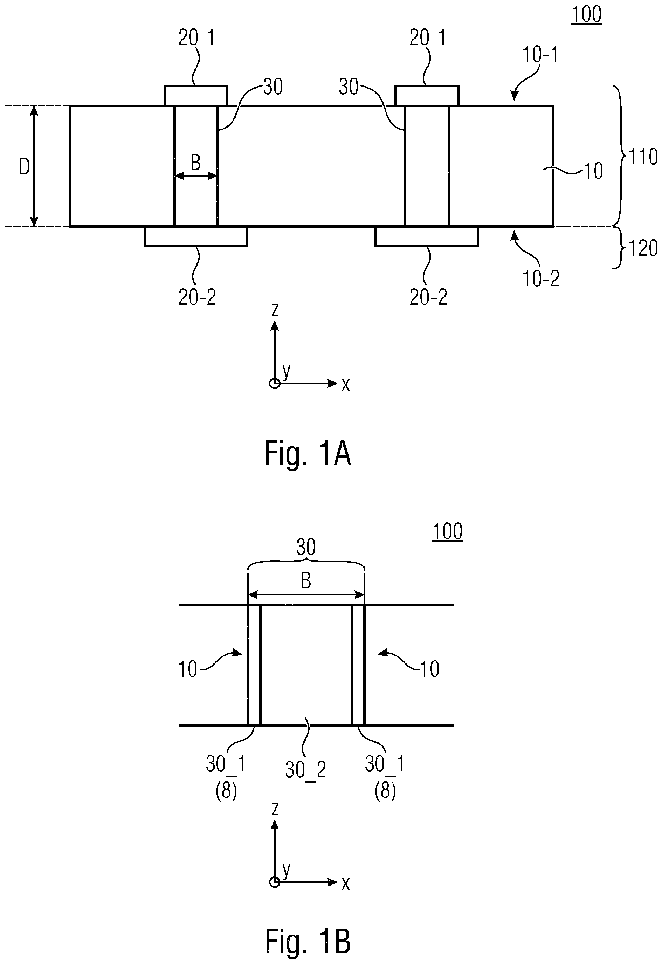

Fig. 1 zeigt eine kryo-kompatible Quanten-Computing-Anordnung 100. Die Anordnung 100 umfasst eine mikroelektrische Quanten-Computing-Komponente 110 mit einer Substratstruktur 10, einer Mehrzahl von ersten Kontaktelementen 20-1 und einer Mehrzahl von leitfähigen Durchführungen (TSVs) 30 durch die Substratstruktur 10. Die leitfähigen Durchführungen 30 sind beispielsweise an einer ersten Hauptoberfläche 10-1 der Substratstruktur 10 mit zugeordneten ersten Kontaktelementen 20-1 der mikroelektronischen Quanten-Computing-Komponente 110 elektrisch verbunden. Ferner umfasst die Quanten-Computing-Anordnung 100 eine weiteren mikroelektronischen Komponente 120 mit einer Mehrzahl von zweiten Kontaktelementen 20-2, wobei an einem zweiten Hauptoberflächenbereich 10-2 der Substratstruktur 10 die leitfähigen Durchführungen 30 mit zugeordneten zweiten Kontaktelementen 20-2 der weiteren mikroelektronischen Komponente 120 elektrisch verbunden sind. Die leitfähigen Durchführungen 30 weisen jeweils zwischen dem ersten Kontaktelement 20-1 und dem zweiten Kontaktelement 20-2 ein Schichtelement 30-1 mit einem ersten Material, das bei einer Quantencomputer-Betriebstemperatur, z.B. unterhalb 10 K, supraleitend ist, und ein Füllelement 30-2 mit einem zweiten Material auf, das elektrisch leitend ist.

Gemäß einem Ausführungsbeispiel füllt das Füllelement zumindest 50 % (oder zumindest 70, 90 oder 99%) des jeweiligen Volumens der leitfähigen Durchführungen entlang des Querschnitts zwischen dem ersten und zweiten Hauptoberflächenbereich der Substratstruktur. Das Füllelement kann das jeweilige Volumen (= Restvolumen der mit dem Schichtelement versehenen Durchführungen) auch vollständig füllen.

Gemäß einem Ausführungsbeispiel ist die kryo-kompatible Quanten-Computing-Anordnung 100 beispielsweise zum Ansteuern von lon-Trap-Qubits in einem lon-Trap-Chip vorgesehen und umfasst die mikroelektrische Quanten-Computing-Komponente 110 mit der Substratstruktur 10, die Mehrzahl von ersten Kontaktelementen 20-1 und die Mehrzahl von leitfähigen Durchführungen (TSVs) 30 durch die Substratstruktur 10. Die leitfähigen Durchführungen (TSVs) 30 sind beispielsweise mit einem Wolfram-basierten Material gefüllt, um beispielsweise eine größere Leitfähigkeit der TSVs 30 auch bei höheren Temperaturen über dem Sprungpunkt der Supraleitfähigkeit bereitzustellen. Die TSVs 30 sind beispielsweise an einer ersten Hauptoberfläche 10-1 der Substratstruktur 10 so angeordnet, dass sie mit den ersten Kontaktelementen 20-1 der mikroelektrischen Quanten-Computing-Komponente 110 direkt angeordnet und elektrisch verbunden sind. Dabei kann jede einzelne Durchführung 30 einem ersten Kontaktelement 20-1 zugeordnet beziehungsweise direkt angegliedert sein. Beispielsweise können die Mehrzahl von zweiten Kontaktelementen 20-2 der weiteren mikroelektrischen Komponente 120 so angeordnet sein, dass jede Durchführung 30 mit den zweiten Kontaktelementen 20-2 an dem zweiten Hauptoberflächenbereich 10-2 zugeordnet beziehungsweise direkt angegliedert sein. Auf diese Weise kann eine elektrische Verbindung beziehungsweise eine Durchkontaktierung durch die Substratstruktur 10 bereitgestellt werden, so dass eine Zusammenschaltung bzw. Zwischenverbindung entsteht.

Wie in Fig. 1A gezeigt, kann der Durchmesser (Breite) der Komponente 20-1 (entsprechend der x-Achse) sich von dem Durchmesser (Breite) der Komponente 20-2 unterscheiden. Alternativ dazu können die Durchmesser der Komponenten 20-1 und 20-2 ein entsprechend gleiches Maß umfassen, beziehungsweise entsprechend gleich sein, so dass beispielsweise die Fläche der Komponenten 20-1 der Fläche des TSVs 30 entspricht. Dadurch kann die Fläche der elektrischen Verbindung minimiert werden, so dass eine hohe Integrationsdichte der Durchgangslöcher 30 in der Substratstruktur 10 erreicht werden kann. Beispielsweise können sich die ersten Kontaktelemente 20-1 von den zweiten Kontaktelementen 20-2 in der Form und dem Material unterscheiden, vorausgesetzt sie sind elektrisch mit dem zugeordneten TSV 30 elektrisch verbunden. Zusätzlich oder alternativ dazu können die Kontaktelemente 20-1 und/oder 20-2 als Bond-Bumps bzw. Bond-Pillars ausgebildet sein, wodurch die elektrische Verbindung hergestellt werden kann.

Wie ferner in Fig. 1A gezeigt ist, wird eine ebene Substratstruktur 10 beziehungsweise ebene Hauptoberflächen 10-1 und 10-2 für eine kryo-kompatible Quanten-Computing-Anordnung 100 verwendet. Alternativ dazu kann eine unebene und/oder stufenförmige Substratstruktur 10 für die leitfähigen Durchführungen 30 bereitgestellt werden. Bei einigen Implementierungen kann mittels stufenförmiger Substratstruktur 10 die Dicke "D" der Substratstruktur 10 (= vertikale Erstreckung der leitfähigen Durchführungen 30) unterschiedlich ausgestaltet sein (entsprechend der z-Achse), wobei das nicht zwingend erforderlich ist.

Die leitfähigen Durchführungen (TSVs) weisen z.B. einen Durchmesser im Bereich von 0,8 µm bis 1,5 µm auf. Ferner können die TSVs einen minimalen TSV-Abstand zueinander aufweisen, der einen Bereich von 1,6 µm bis 3 µm umfasst. Beispielsweise kann die TSV-Tiefe in das Substrat mindestens 6 µm bis 10 µm aufweisen. Ferner kann die leitfähige Durchführung ein Seitenverhältnis von 10:1 bis 20:1 aufweisen, um eine möglichst hohe Integrationsdichte in dem Substrat zu erreichen, so dass die hohe Verdrahtungsdichte eine hohe Anzahl der Qubits ansteuern kann.

Die Zusammenschaltungen oder Zwischenverbindungen (Interconnects) werden hergestellt beispielsweise mittels einem kryo-kompatiblen intermetallischen Bondverfahren mit sehr hoher Integrationsdichte, durch Metall-Interdiffusionsverfahren, z. B. auf der Basis des Metall-Systems Nb/TiN/Au. Diese Vorgehensweise ermöglicht insbesondere eine Skalierbarkeit der Kontaktierungsanordnungen bei Quanten-Computing- Anwendungen, da mittels Anwendungs-optimierter Zusammenschaltungstechnologie in Kombination mit Wolfram-TSVs z. B. die Anzahl der angesteuerten Ion-Trap Qubits um mehrere Größenordnungen (i.W. beliebig) gesteigert werden kann.

Die Kontaktverbindung zwischen den Kontaktelementen 20-1 der mikroelektronischen Quenten-Computing-Komponente 110 kann beispielsweise eine kryo-kompatible interdiffusionsmetallische Verbindung aufweisen. Gemäß einem Ausführungsbeispiel können Interdiffusionsmetallische Verbindungen zusätzlich oder alternativ an dem ersten Hauptoberflächenbereich 10-1 der Substratstruktur 10 mit den Kontaktelementen 20-2 der weiteren mikroelektronischen Komponente 120 aufweisen. Die interdiffusionsmetallische Verbindungen an dem ersten Hauptoberflächenbereich 10-1 und an den Kontaktverbindungen zwischen den Kontaktelementen 20-1 ermöglichen es, eine hohe Integrationsdichte der leitfähigen Durchführungen 30 in der Substratstruktur 10 der mikroelektrischen Quanten-Computing-Komponente 100 zu realisieren, um die Anzahl der anzusteuernden lon-Trap-Qubits zu steigern.

Gemäß einem Ausführungsbeispiel sind die Kontaktelemente 20-1 der mikroelektronischen Quanten-Computing-Komponente 110 beispielsweise mit einer Mehrzahl von leitfähigen Durchführungen 30 in einer Parallelschaltung verbunden.

Gemäß einem Ausführungsbeispiel sind die Mehrzahl von leitfähigen Durchführungen 30 beispielsweise mittels eines Isolationsmaterials 34 von der Substratstruktur 10 elektrisch isoliert.

Gemäß einem Ausführungsbeispiel füllt das Füllelement die leitfähigen Durchführungen 30 beispielsweise jeweils vollständig mit einem Wolfram-Material aus.

Gemäß einem Ausführungsbeispiel weist das Schichtelement eine Beta-Modifikation von Wolfram auf, wobei das Füllelement ein Wolfram-Material aufweist.

Gemäß einem Ausführungsbeispiel ist zur Erhaltung der Beta-Modifikation des Wolframs des Schichtelements beispielsweise das Wolfram als eine Schicht 30-1 in den leitfähigen Durchführungen 30 des Substrats 10 angeordnet, wobei angrenzend an das Schichtelement des Beta-Wolfram-Materials 30-1 eine weitere Schicht 5; 7 eines weiteren Materials angeordnet ist, das einen höheren Wärmeausdehnungskoeffizienten als das Wolfram-Material aufweist.

Gemäß einem Ausführungsbeispiel ist angrenzend an das Schichtelement mit der Beta-Modifikation des Wolfram-Materials 30-1 beispielsweise eine weitere Schicht 5; 7 mit einem weiteren Material angeordnet, das einen höheren Wärmeausdehnungskoeffizienten als das Wolfram-Material aufweist.

Gemäß einem Ausführungsbeispiel ist angrenzend an das Schichtelement mit der Beta-Modifikation des Wolfram-Materials 30-1 beispielsweise jeweils beidseitig eine weitere Schicht 5; 7 mit einem weiteren Material angeordnet, das jeweils einen höheren Wärmeausdehnungskoeffizienten als das Wolfram-Material aufweist.

Wie bereits erläutert, erhöht die zumindest teilweise oder auch vollständige Füllung der TSVs mit Wolfram zudem die Leitfähigkeit der TSVs bei schon höheren Temperaturen über dem Sprungpunkt der Supraleitfähigkeit. Titannitrid hat in diesem Temperaturbereich eine deutlich schlechtere Leitfähigkeit. Die Supraleitfähigkeit der TSVs kann also in dem Temperaturbereich der Anwendungstemperaturen des Quanten-Computing von 10-1000 mK erreicht werden. Ferner kann ein Funktionstest der mit Wolfram gefüllten oder ausgekleideten Durchführungen (TSVs) der kryo-kompatiblen Quanten-Computing-Anordnung zuverlässig bei Temperaturen um 70°K (Stickstofftemperatur) durchgeführt werden, bevor die Zwischenverbindungen bzw. die Umverdrahtung bei den Anwendungstemperaturen unterhalb der Supraleitfähigkeit eingesetzt wird. Dies vereinfacht das aufwendige, kostenintensive Testen und verringert somit wesentlich die Produktionskosten des lon-Trap-Chips. Ferner kann die kryo-kompatible Quanten-Computing-Anordnung bereits auf Wafer-Ebene, zum Beispiel Die-on-Chip-Wafer, getestet und im Folgenden dann funktionsfähig bei den kryogenen Temperaturen der Quanten-Computing-Anwendung eingesetzt werden. Dadurch ist das aufwendige Testen in speziellen Kryo-Testsystemen bei Temperaturen unterhalb der Supraleitfähigkeit nicht mehr notwendig. In anderen Worten kann das aufwendige Kühlen unter Verwendung von Helium, beispielsweise Helium-3 oder beispielsweise Helium-4, für den Kryo-Temperaturbereich unterhalb des Sprungpunkts für die Supraleitfähigkeit vermieden werden.

Fig. 1B zeigt eine schematische Schnittdarstellung der leitfähigen Durchführung 30 mit einem Schichtelement 30-1 und einem Füllelement 30-2 gemäß einem Ausführungsbeispiel. Beispielsweise kann das Füllelement 30-2 zumindest 50% des jeweiligen Volumens der leitfähigen Durchführungen 30 entlang des Querschnitts zwischen dem ersten Hauptoberflächen-bereich 10-1 und zweiten Hauptoberflächenbereich 10-2 der Substratstruktur 10 füllen. Die leitfähigen Durchführungen 30 verlaufen wie bereits in Fig. 1A dargestellt jeweils zwischen dem ersten und zweiten Kontaktelement und erstrecken sich wie bereits erläutert durch die gesamte Substratstruktur 10. Beispielsweise kann das Schichtelement 30-1 ein erstes Material aufweisen, das bei einer Quantencomputer-Betriebstemperatur, also im Betriebsmodus der Quanten-Computing-Anordnung supraleitend ist. Das Füllelement 30-2 weist ein elektrisch leitendes Material oder eine elektrisch leitende Legierung auf, wie beispielswiese Wolfram, Niob (Ni), Tantal (Ta), Titannitrid (TiN), Platin (Pt), Palladium (Pd), Nickel (Ni), Kupfer (Cu), Aluminium (Al), Titan (Ti) oder Blei (Pb) oder eine elektrisch leitende Legierung aufweisen. Diese Aufzählung ist nicht als abschließend anzusehen.

Das Schichtelement 30-1 der TSVs 30, welches bei kryogenen Temperaturen supraleitfähig ist, kann z. B. Wolfram-Schichten mit beta-Struktur oder Sandwich-Strukturen aus dünnen Wolfram und weiteren dünnen Schichten aus kryo-kompatiblen Materialen sein, um die Supraleitfähigkeit bei den Anwendungstemperaturen des Quantencomputers (10-1000 mK Bereich) in Helium- oder Helium-Misch-Kryostaten zu realisieren.

Bei einem Schichtstapel 8 mit dem Schichtelement 30-1 und einer weiteren angrenzenden Schicht oder mehreren Schichten kann das Schichtelement z.B. Wolfram mit einer angrenzenden Titannitrid-Schicht (als die weitere Schicht) aufweisen oder zwischen Titannitrid-Schichten (als die weiteren Schichten) angeordnet sein. Ferner kann der Schichtstapel auch Niob (als Schichtelement) mit einer angrenzenden Titannitrid-Schicht (als die weitere Schicht) aufweisen oder zwischen Titannitrid-Schichten (als die weiteren Schichten) angeordnet sein oder Tantal (als Schichtelement) mit einer angrenzenden Titannitrid-Schicht (als die weitere Schicht) aufweisen oder zwischen Titannitrid-Schichten (als die weiteren Schichten) angeordnet sein. Beispielsweise kann die weitere Schicht bzw. die weiteren Schichten neben (= anstelle von) Titannitrid (TiN) auch Wolframdisulfid (WS2), Platin (Pt), Palladium (Pd), Nickel (Ni), Aluminium (Al) und/oder Aluminiumoxid (Al2O3) aufweisen. Gemäß einem Ausführungsbeispiel kann das Schichtelement 30-1 oder der Schichtstapel 8 mit dem Schichtelement 30-1 einen Teil des Wandbereichs oder den gesamten Wandbereich der Durchführung 30 als Schicht bedecken, während das Füllelement 30-2 das restliche Volumen der Durchführung 30 zumindest teilweise (zumindest zu 50 %) oder auch vollständig ausfüllt. Das Schichtelement 30-1 bzw. der Schichtstapel kann das Füllelement 30-2 also zwischen dem ersten Kontaktelement 20-1 und dem zweiten Kontaktelement 20-2 teilweise oder bereichsweise (oder lateral vollständig) umschließen, wobei sich sowohl das Schichtelement 30-1 als auch das Füllelement 30-2 von dem ersten Kontaktelement 20-1 zu dem zweiten Kontaktelement 20-2 erstreckt und diese miteinander verbindet. Gemäß einem weiteren Ausführungsbeispiel kann das Schichtelement 30-1 oder der Schichtstapel mit dem Schichtelement den Wandbereich der Durchführung 30 als Schicht vollständig bedecken, während das Füllelement 30-2 das restliche Volumen der Durchführung 30 zumindest teilweise (zumindest zu 50 %) oder auch vollständig ausfüllt. Das Schichtelement 30-1 kann das Füllelement 30-2 auch vollständig (z.B. mantelförmig) umschließen, wobei sich auch hier sowohl das Schichtelement 30-1 als auch das Füllelement 30-2 von dem ersten Kontaktelement 20-1 zu dem zweiten Kontaktelement 20-2 erstreckt und diese miteinander verbindet.

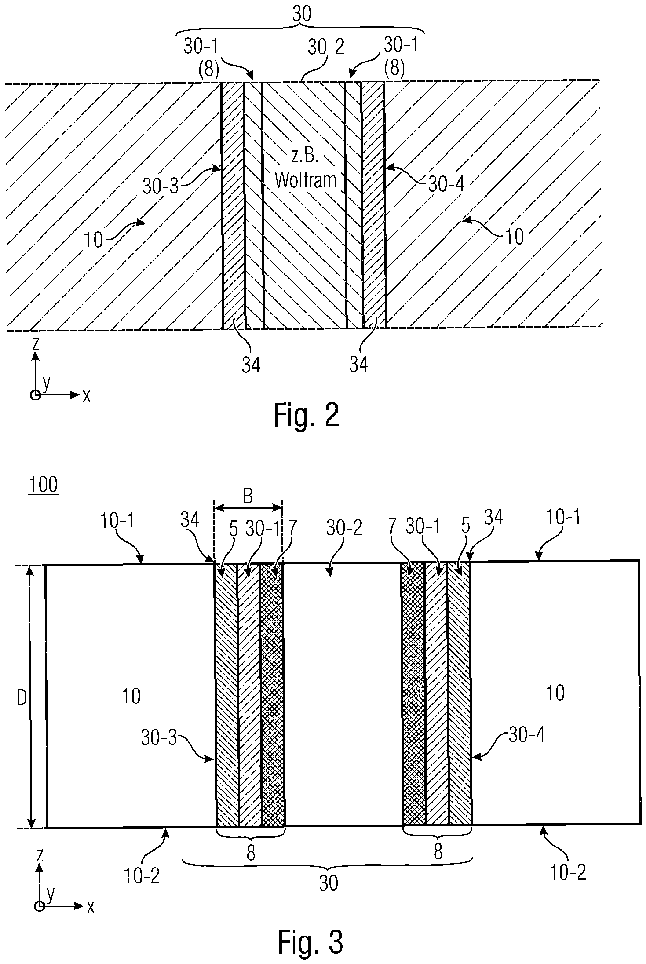

Fig. 2 zeigt eine schematische Schnittdarstellung eines TSVs 30, das in der Substratstruktur 10 durchgehend ausgebildet ist. Gemäß einem Ausführungsbeispiel können die TSVs 30 mittels eines Isolationsmaterials 34 beziehungsweise einer Isolationsschicht an den Seitenwänden 30-3 und 30-4 der Durchführungen 30 von der Substratstruktur 10 elektrisch isoliert und mit dem Füllelement 30-2 und dem Schichtelement 30-1 zumindest teilweise oder vollständig gefüllt sein. Fig. 2 veranschaulicht beispielsweise die isolierte leitfähige Durchführung 30, die vollständig mit einem Wolfram Material ausgefüllt ist. Beispielsweise kann das Isolationsmaterial 34 Siliziumdioxid, Glas, Kunststoff und/oder Titannitrid umfassen. Mittels des Isolationsmaterials 34 an den Seitenwänden 30-3 und 30-4 der Durchführung 30 kann eine elektrische Trennung ermöglicht werden, so dass die elektrisch leitende Verbindung von den ersten Kontaktelementen 20-1 zu den zweiten Kontaktelementen 20-2 bereitgestellt werden kann. Beispielsweise können die Kontaktelemente 20-1 der mikroelektrischen Quanten-Computing-Komponente 110 mit einer Mehrzahl von TSVs 30 in einer Parallelschaltung, zum Beispiel zur Widerstandsverminderung, verbunden sein. Ausführungsbeispiele sehen dabei ferner vor, dass das Füllelement 30-2 oder das Schichtelement 30-1 direkt angrenzend zur Isolationsschicht 34 angebracht ist. Darüber hinaus ist es möglich, dass beispielsweise bereichsweise oder einzeln parallelschaltbare TSVs verschaltet (miteinander verbunden) werden können, etwa indem ein Bereich, eine Reihe oder Aufstellung, z. B. nxm mit n ≥ 2 und m ≥ 2 und n, m sind ganze Zahlen, wie z. B. 2x2, 3x3, 4x4 oder 5x5, etc., parallelverschalteten TSVs bereitgestellt wird.

Fig. 3 zeigt eine schematische Schnittdarstellung einer kryo-kompatiblen Quanten-Computing-Anordnung gemäß einem Ausführungsbeispiel mit einem Schichtstapel 8 an den Seitenwänden 30-3 und 30-4 der TSVs 30. Dabei umfasst der Sichtstapel 8 das Schichtelement 30-1 und die weiteren angrenzenden Schichten 5, 7. Das Wolfram-Material kann mittels des erfindungsgemäßen Verfahrens, Temperatur und Anwendung unterschiedliche Strukturen oder Phasen aufweisen. Wie bereits erläutert, weisen die Wolfram-Phasen (Alpha-Phase und Beta-Phase) unterschiedlich hohe Sprungtemperaturen auf. In anderen Worten hat Wolfram in der Alpha-Phase beziehungsweise in der Alpha-Struktur eine niedrigere Sprungtemperatur als die Beta-Struktur beziehungsweise in der Beta-Phase des Wolframs. Um den Implementierungsaufwand möglichst gering zu halten, ist die Beta-Struktur (Beta-Phase) des Wolframs dem Alpha-Wolfram vorzuziehen, so dass eine möglichst hohe Sprungtemperatur des Wolframs erzielt wird. Die Supraleitfähigkeit der TSVs kann also in dem Temperaturbereich der Anwendungstemperaturen des Quanten-Computing von 10-1000 mK erreicht werden. Ferner kann ein Funktionstest der mit dem Wolfram-basierten Material gefüllten Durchführungen (TSVs) der kryo-kompatiblen Quanten-Computing-Anordnung zuverlässig bei Temperaturen um 70°K (Stickstofftemperatur) durchgeführt werden.

Gemäß Ausführungsbeispielen wird zur Erzielung der hohen Sprungtemperatur des Wolframs das Wolfram während des Kühlprozesses, d.h. des Abkühlvorgangs, stets unter Druckspannung gehalten. Dadurch kann die Beta-Phase des Wolframs erhalten werden, welches eine höhere Sprungtemperatur besitzt als andere Wolfram-Phasen. Daher wird die Wolfram-Schicht 30-1 zwischen einer weiteren Schicht 5 und 7 eines weiteren Materials eingebettet, welches einen höheren Wärmeausdehnungskoeffizienten hat als das Wolfram Material 30-1.

Wie in Fig. 3 gezeigt, ist die Wolfram-Schicht 30-1 zwischen der weiteren Schicht 5 mit höherem Wärmeausdehnungskoeffizienten als Wolfram und der weiteren Schicht 7 mit höherem Wärmeausdehnungskoeffizienten als Wolfram eingebettet, so dass beispielsweise ein Sandwich-Schichtstapel 8 entsteht. Auf diese Weise kann der Schichtstapel 8 unter Verwendung eines Abscheideverfahrens beispielsweise des Wolfram-Gasphasenabscheideverfahrens schichtweise an die Isolationsschicht 34 abgeschieden werden. Wie bereits erläutert, kann die weitere Schicht 5, die weitere Schicht 7 oder beide weitere Schichten 5 und 7 Titannitrid (TiN), Wolframdisulfid (WS₂), Platin (Pt), Palladium (Pd), Nickel (Ni), Aluminium (Al) und/oder Aluminiumoxid (Al₂O₃) aufweisen.

Bei einem Schichtstapel 8 mit dem Schichtelement 30-1 und einer weiteren angrenzenden Schicht 5 oder mehreren Schichten 5, 7 kann also das Schichtelement 30-1 z.B. Wolfram mit einer angrenzenden Titannitrid-Schicht (als die weitere Schicht 5 oder 7) aufweisen oder zwischen Titannitrid-Schichten (als die weiteren Schichten 5 und 7) angeordnet sein. Ferner kann der Schichtstapel 8 auch Niob (als Schichtelement 30-1) mit einer angrenzenden Titannitrid-Schicht (als die weitere Schicht 5 oder 7) aufweisen oder zwischen Titannitrid-Schichten (als die weiteren Schichten 5 und 7) angeordnet sein oder Tantal (als Schichtelement 30-1) mit einer angrenzenden Titannitrid-Schicht (als die weitere Schicht 5 oder 7) aufweisen oder zwischen Titannitrid-Schichten (als die weiteren Schichten 5 und 7) angeordnet sein. Beispielsweise kann die weitere Schicht 5 oder 7 bzw. die weiteren Schichten 5 und 7 neben (= anstelle von) Titannitrid (TiN) auch Wolframdisulfid (WS2), Platin (Pt), Palladium (Pd), Nickel (Ni), Aluminium (Al) und/oder Aluminiumoxid (Al2O3) aufweisen.

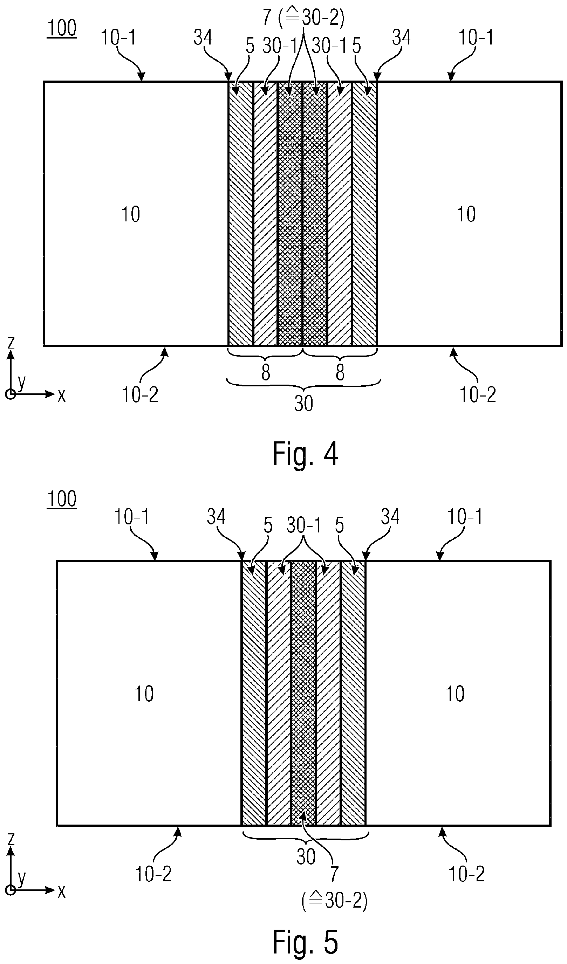

Fig. 4 veranschaulicht eine kryo-kompatible Quanten-Computing-Anordnung gemäß einem weiteren Ausführungsbeispiel mit zwei Schichtstapeln 8 nebeneinander, die miteinander beispielsweise direkt verbunden sind. Die Quanten-Computing-Anordnung umfasst wie bereits in Fig. 5 gezeigt eine Substratstruktur 10, ein Isolationsmaterial 34 im TSV 30, bzw. zwischen der Substratstruktur 10 und der weiteren Schicht 5, und ein Schichtelement 30-1 (z.B. eine Wolframschicht etc). Im Gegensatz zu den in Fig. 3 aufgezeigten Schichtstapeln 8, sehen Ausführungsbeispiele dabei ferner vor, die Schichtstapel 8 direkt miteinander zu verbinden. So kann beispielsweise der Schichtstapel 8 den Wandbereich der Durchführung 30 so bedecken, dass die Durchführung (z.B. vollständig) gefüllt ist. Wie in Fig. 4 aufgezeigt ist, kann die weitere Schicht 7 im TSV 30 entsprechend zweimal enthalten. Zusätzlich oder alternativ kann das Material der Schicht 7 eine entsprechend dicke Schicht aufweisen, um das Füllelement 30-2 zu bilden, oder beispielsweise wie die Schichtdicken der weiteren Schicht 5 und/oder des Schichtelements 30-1 (z.B. die Wolfram-Schicht), wobei das nur bespielhaft ist.

Ferner ermöglichen es Ausführungsbeispiele, dass eine Quanten-Computing-Anordnung gemäß einem Ausführungsbeispiel nur eine weitere Schicht 7 umfasst. Im Gegensatz zu der Darstellung in Fig. 4 zeigt die Darstellung in Fig. 5 eine Quanten-Computing-Anordnung mit nur einer einzigen weiteren Schicht 7 (entspricht z.B. dem Füllelement 30-2), die einen höheren Wärmeausdehnungskoeffizienten als Wolfram hat. Darüber hinaus ist es möglich die jeweiligen Schichten 34, 5, 30-1 und 7 so abzuscheiden, dass die Wolfram-Schicht 30-1 einen möglichst großen Anteil des Materials der leitfähigen Durchführung 30 umfasst, beispielsweise im Bereich von 50 % bis 99 % oder 60 % bis 90 % oder 70 % bis 80 %. Hierdurch kann die elektrische Eigenschaft der elektrischen Verbindung definiert werden, etwa indem die Wolfram-Schicht 30-1 entsprechend den Quanten-Computing-Anforderungen dimensioniert wird.

Die in Fig. 5 dargestellten Schichten 5, 7 , 30-1, 30-2, 34 etc. können entsprechend auch die anhand von Fig. 4 beschriebenen Materialien oder Materialkombinationen aufweisen. Die Quanten-Computing-Anordnung erlaub eine besonders einfache Herstellbarkeit einer dreidimensionalen Struktur zum Ansteuern von lon-Trap-Quibits in einem Ion-Trap Chip, da zum einen die mikroelektronischen Komponenten vor dem Einsatz bei kryogenen Temperaturen getestet werden können und zum anderen eine hohe Integrationsdichte der TSVs basierend auf Metallinterdiffusionsverfahren erreicht wird, um möglichst viele Ion-Trap Qubits anzusteuern.

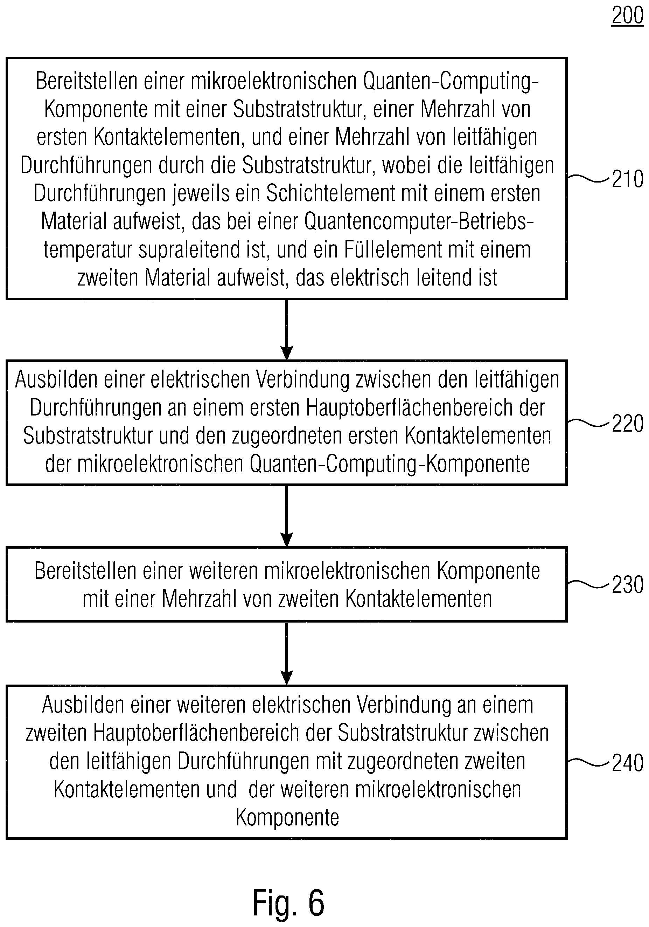

Fig. 6 zeigt ein Verfahren 200 zum Herstellen einer kryo-kompatiblen Anordnung gemäß eines Ausführungsbeispiels. Das Verfahren umfasst ein Bereitstellen 210 einer mikroelektronischen Quanten-Computing-Komponente mit einer Substratstruktur, einer Mehrzahl von ersten Kontaktelementen, und einer Mehrzahl von leitfähigen Durchführungen durch die Substratstruktur, wobei die leitfähigen Durchführungen jeweils ein Schichtelement mit einem ersten Material auf-weist, das bei einer Quantencomputer-Betriebstemperatur supraleitend ist, und ein Füllelement mit einem zweiten Material aufweist, das elektrisch leitend ist. Ferner umfasst das Verfahren ein Ausbilden 220 einer elektrischen Verbindung zwischen den leitfähigen Durchführungen an einem ersten Hauptoberflächenbereich der Substratstruktur und den zugeordneten ersten Kontaktelementen der mikroelektronischen Quanten-Computing-Komponente und ein Bereitstellen 230 einer weiteren mikroelektronischen Komponente mit einer Mehrzahl von zweiten Kontaktelementen. Ferner umfasst das Verfahren ein Ausbilden 240 einer weiteren elektrischen Verbindung an einem zweiten Hauptoberflächenbereich der Substratstruktur zwischen den leitfähigen Durchführungen mit zugeordneten zweiten Kontaktelementen und der weiteren mikroelektronischen Komponente.

Gemäß Ausführungsbeispielen umfasst der Schritt 210 des Bereitstellens der leitfähigen Durchführungen beispielsweise ein Aufbringen 250 des Wolfram-Materials des Schichtelements unter Druckspannung in Durchführungen, um die Beta-Modifikation des Wolfram-Materials zu erzielen und ein Zumindest teilweises oder vollständiges Ausfüllen 260 der Durchführungen mit einem Wolfram- Material, um die leitfähigen Durchführungen zu erhalten.

Ferner umfasst das Verfahren beispielsweise ein Anordnen 270 einer weiteren Schicht mit einem Material, das einen höheren Wärmeausdehnungskoeffizienten als das Wolfram-Material, angrenzend an das Schichtelement mit der Beta-Modifikation des Wolfram-Materials.

Ferner umfasst das Verfahren beispielsweise ein Anordnen 280 jeweils beidseitig einer weiteren Schicht mit einem Material, das einen höheren Wärmeausdehnungskoeffizienten als das Wolfram-Material, angrenzend an das Schichtelement mit der Beta-Modifikation des Wolfram-Materials.

Die TSVs werden vollständig mittels Wolfram-Gasphasenabscheidung, z. B. mittels Wolfram-Hexaflorid und Wasserstoffgas gefüllt. Die vollständige Füllung der TSVs realisiert vorteilhafterweise vergleichsweise zu TiN benetzten TSVs größere Leitfähigkeit der TSVs bei schon höheren Temperaturen über dem Sprungpunkt der Supraleitfähigkeit. Dies erleichtert wesentlich die Testbarkeit der integrierten mikroelektronischen Komponenten bevor diese bei den Anwendungstemperaturen unterhalb der Supraleitfähigkeit eingesetzt werden. Dies vereinfacht wesentlich das üblicherweise kostenintensive Testen und erniedrigt somit wesentlich die Produktionskosten des integrierten Quanten-Chip Systems. Die Systeme (Quanten Chips) können darüber hinaus ohne Einschränkung der Allgemeinheit bereits auf Wafer-Ebene (bzw. Die-On-Wafer) getestet werden und nach üblicher Known-Good-Die-Strategie aufgebaut und sodann funktionsfähig bei den kryogenen Temperaturen der Quantencomputeranwendungen eingesetzt werden. Dadurch ist vorteilhafterweise das sehr kosten-intensive Testen in speziellen Kryo-Testsystemen bei Temperaturen unterhalb der Supraleitfähigkeit nicht notwendig.

Um eine möglichst hohe Sprungtemperatur des Wolframs zu erzielen, ist es vorteilhaft, wenn das abgeschiedene Wolfram während des Kühlungsprozesses des Systems stets unter Druckspannung verbleibt. Hierdurch wird die β-Phase des Wolframs erhalten, welche eine höhere Sprungtemperatur besitzt als andere Wolfram-Phasen. Hierfür ist es vorteilhaft, wenn die Wolfram-Schicht zwischen Material eingebettet ist, welches einen höheren Wärmeausdehnungskoeffizienten hat als Wolfram, beispielsweise Titannitrid (TiN), Wolframdisulfid (WS₂), Platin (Pt), Palladium (Pd), Nickel (Ni), Aluminium (Al) und/oder Aluminiumoxid (Al₂O₃).

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind. Vielmehr kann, wie die folgenden Ansprüche wiedergeben, der Gegenstand in weniger als allen Merkmalen eines einzelnen offenbarten Beispiels liegen. Folglich werden die folgenden Ansprüche hiermit in die detaillierte Beschreibung aufgenommen, wobei jeder Anspruch als ein eigenes separates Beispiel stehen kann. Während jeder Anspruch als ein eigenes separates Beispiel stehen kann, sei angemerkt, dass, obwohl sich abhängige Ansprüche in den Ansprüchen auf eine spezifische Kombination mit einem oder mehreren anderen Ansprüchen zurückbeziehen, andere Beispiele auch eine Kombination von abhängigen Ansprüchen mit dem Gegenstand jedes anderen abhängigen Anspruchs oder einer Kombination jedes Merkmals mit anderen abhängigen oder unabhängigen Ansprüchen umfassen. Solche Kombinationen seien umfasst, es sei denn es ist ausgeführt, dass eine spezifische Kombination nicht beabsichtigt ist. Ferner ist beabsichtigt, dass auch eine Kombination von Merkmalen eines Anspruchs mit jedem anderen unabhängigen Anspruch umfasst ist, selbst wenn dieser Anspruch nicht direkt abhängig von dem unabhängigen Anspruch ist. Obwohl spezifische Ausführungsbeispiele hierin dargestellt und beschrieben wurden, wird einem Fachmann offensichtlich sein, dass eine Vielzahl von alternativen und/oder äquivalenten Implementierungen für die spezifischen dort gezeigten und dargestellten Ausführungsbeispiele ersetzt werden können, ohne von dem Gegenstand der vorliegenden Anmeldung abzuweichen. Dieser Anmeldungstext soll alle Adaptionen und Variationen der hierin beschriebenen und erörterten spezifischen Ausführungsbeispiele abdecken. Daher ist der vorliegende Anmeldungsgegenstand lediglich durch den Wortlaut der Ansprüche begrenzt.

### Referenzen:

EP 2 876 435 B1
US 6,548,391
Tao et al., "3D Integration of CMOS-Compatible Surface Electrode Ion Trap and Silicon Photonics for Scalable Quantum Computing," 2019 IEEE 69th Electronic Components and Technology Conference (ECTC), Las Vegas, NV, USA, 2019, pp. 1735-1743, doi: 10.1109/ECTC.2019.00266
Yost et al., "Solid-state qubits integrated with superconducting through-silicon vias", npj Quantum Information (2020) 59
K. Grigoras et al., "Superconducting TiN through-silicon-vias for quantum technology; IEEE 2019 21st Electronics Packaging Technology Conference"
LITA et al.: Tuning of Tungsten Thin Film Superconducting Transition Temperature for Fabrication of Photon Number Resolving Detectors; IEEE TRANSACTIONS ON APPLIED SUPERCONDUCTIVITY, VOL. 15, NO,.2, JUNE 2005

## Patentansprüche

1. Kryo-kompatible Quanten-Computing-Anordnung (100), mit folgenden Merkmalen:
einer mikroelektronischen Quanten-Computing-Komponente (110) mit
einer Substratstruktur (10),
einer Mehrzahl von ersten Kontaktelementen (20-1), und
einer Mehrzahl von leitfähigen Durchführungen (30) durch die Substratstruktur (10),
wobei die leitfähigen Durchführungen (30) an einem ersten Hauptoberflächenbereich (10-1) der Substratstruktur (10) mit zugeordneten ersten Kontaktelementen (20-1) der mikroelektronischen Quanten-Computing-Komponente (110) elektrisch verbunden sind, und
einer weiteren mikroelektronischen Komponente (120) mit einer Mehrzahl von zweiten Kontaktelementen (20-2),
wobei an einem zweiten Hauptoberflächenbereich (10-2) der Substratstruktur (10) die leitfähigen Durchführungen (30) mit zugeordneten zweiten Kontaktelementen (20-2) der weiteren mikroelektronischen Komponente (120) elektrisch verbunden sind, und
**dadurch gekennzeichnet, dass** die leitfähigen Durchführungen (30) jeweils zwischen dem ersten Kontaktelement (20-1) und dem zweiten Kontaktelement (20-2) ein Schichtelement (30-1) mit einem ersten Material mit einer Beta-Modifikation von Wolfram, das bei einer Quantencomputer-Betriebstemperatur unter der Sprungtemperatur für die Supraleitfähigkeit supraleitend ist, und ein Füllelement (30-2) mit einem zweiten Material aufweisen, das über der Sprungtemperatur für die Supraleitfähigkeit elektrisch leitend ist.

2. Anordnung gemäß Anspruch 1, wobei das Schichtelement (30-1) einen Teil des Wandbereichs oder den gesamten Wandbereich der Durchführung (30) darstellt, und wobei das Füllelement (30-2) zumindest 50% des jeweiligen Volumens der leitfähigen Durchführungen (30) entlang des Querschnitts zwischen dem ersten Hauptoberflächenbereich (10-1) und zweiten Hauptoberflächenbereich (10-2) der Substratstruktur (10) füllt.

3. Anordnung gemäß Anspruch 1 oder 2, wobei die Kontaktelemente (20-1; 20-2) als Bond-Bumps bzw. Bond-Pillars ausgebildet sind.

4. Anordnung gemäß einem der vorhergehenden Ansprüche, wobei die Kontaktverbindung zwischen den Kontaktelementen (20-1) der mikroelektronischen Quanten-Computing-Komponente (110) eine kryo-kompatible, mit einem Metall-Interdiffusionsverfahren hergestellte Verbindung aufweist.

5. Anordnung gemäß einem der vorhergehenden Ansprüche, wobei die Kontaktelemente (20-1) an dem ersten Hauptoberflächenbereich (10-1) der Substratstruktur (10) mit den Kontaktelementen (20-2) der weiteren mikroelektronischen Komponente (120) mit einem Metall-Interdiffusionsverfahren hergestellte Verbindungen aufweisen.

6. Anordnung gemäß einem der vorhergehenden Ansprüche, wobei die Kontaktelemente (20-1) der mikroelektronischen Quanten-Computing-Komponente (110) mit einer Mehrzahl von leitfähigen Durchführungen (30) in einer Parallelschaltung verbunden sind.

7. Anordnung gemäß einem der vorhergehenden Ansprüche, wobei die Mehrzahl von leitfähigen Durchführungen (30) mittels eines Isolationsmaterials (34) von der Substratstruktur (10) elektrisch isoliert sind.

8. Anordnung gemäß einem der vorhergehenden Ansprüche, wobei das Füllelement (30-2) die leitfähigen Durchführungen (30) jeweils vollständig mit einem Wolfram Material ausfüllt.

9. Anordnung gemäß einem der vorhergehenden Ansprüche, wobei das Füllelement (30-2) ein Wolfram-Material aufweist.

10. Anordnung gemäß Anspruch 9, wobei zur Erhaltung der Beta-Modifikation des Wolframs des Schichtelements (30-1) das Wolfram als eine Schicht in den leitfähigen Durchführungen (30) des Substrats (10) angeordnet ist, wobei angrenzend an das Schichtelement (30-1) mit der Beta-Modifikation des Wolfram-Materials eine weitere Schicht (5; 7) eines weiteren Materials angeordnet ist, das einen höheren Wärmeausdehnungskoeffizienten als das Wolfram-Material aufweist.

11. Anordnung gemäß Anspruch 9 oder 10, wobei angrenzend an das Schichtelement (30-1) mit der Beta-Modifikation des Wolfram-Materials eine weitere Schicht (5; 7) mit einem weiteren Material angeordnet ist, das einen höheren Wärmeausdehnungskoeffizienten als das Wolfram-Material aufweist.

12. Anordnung gemäß Anspruch 11, wobei angrenzend an das Schichtelement (30-1) mit der Beta-Modifikation des Wolfram-Materials jeweils beidseitig eine weitere Schicht (5; 7) mit einem weiteren Material angeordnet ist, das jeweils einen höheren Wärmeausdehnungskoeffizienten als das Wolfram-Material aufweist.

13. Verfahren (200) zum Bereitstellen einer kryo-kompatiblen Quanten-Computing-Anordnung, wobei das Verfahren aufweist:
Bereitstellen (210) einer mikroelektronischen Quanten-Computing-Komponente mit einer Substratstruktur, einer Mehrzahl von ersten Kontaktelementen, und einer Mehrzahl von leitfähigen Durchführungen durch die Substratstruktur, wobei die leitfähigen Durchführungen jeweils ein Schichtelement mit einem ersten Material mit einer Beta-Modifikation von Wolfram, das bei einer Quantencomputer-Betriebstemperatur unter der Sprungtemperatur der Supraleitfähigkeit supraleitend ist, und ein Füllelement mit einem zweiten Material aufweisen, das über der Sprungtemperatur der Supraleitfähigkeit elektrisch leitend ist,
Ausbilden (220) einer elektrischen Verbindung zwischen den leitfähigen Durchführungen an einem ersten Hauptoberflächenbereich der Substratstruktur und den zugeordneten ersten Kontaktelementen der mikroelektronischen Quanten-Computing-Komponente,
Bereitstellen (230) einer weiteren mikroelektronischen Komponente mit einer Mehrzahl von zweiten Kontaktelementen, und
Ausbilden (240) einer weiteren elektrischen Verbindung an einem zweiten Hauptoberflächenbereich der Substratstruktur zwischen den leitfähigen Durchführungen mit zugeordneten zweiten Kontaktelementen und der weiteren mikroelektronischen Komponente.

14. Verfahren gemäß Anspruch 13, wobei der Schritt (210) des Bereitstellens der leitfähigen Durchführungen folgende Teilschritte aufweist:
Aufbringen (250) des Wolfram-Materials des Schichtelements unter Druckspannung in Durchführungen, um die Beta-Modifikation des Wolfram-Materials zu erzielen; und
zumindest teilweises oder vollständiges Ausfüllen (260) der Durchführungen mit einem Wolfram-Material, um die leitfähigen Durchführungen zu erhalten.

15. Verfahren gemäß Anspruch 14, ferner mit folgendem Schritt:
Anordnen (270) einer weiteren Schicht mit einem Material, das einen höheren Wärmeausdehnungskoeffizienten als das Wolfram-Material, angrenzend an das Schichtelement mit der Beta-Modifikation des Wolfram-Materials.

16. Verfahren gemäß Anspruch 14 oder 15, ferner mit folgendem Schritt:
Anordnen (280) jeweils beidseitig einer weiteren Schicht mit einem Material, das
einen höheren Wärmeausdehnungskoeffizienten als das Wolfram-Material aufweist, angrenzend an das Schichtelement mit der Beta-Modifikation des Wolfram-Materials.

## Claims

1. Cryo-compatible quantum computing arrangement (100), comprising:
a microelectronic quantum computing component (110) with
a substrate structure (10),
a plurality of first contact elements (20-1), and
a plurality of conductive feedthroughs (30) through the substrate structure (10),
wherein the conductive feedthroughs (30) are electrically connected at a first main surface region (10-1) of the substrate structure (10) to associated first contact elements (20-1) of the microelectronic quantum computing component (110), and
a further microelectronic component (120) with a plurality of second contact elements (20-2),
wherein the conductive feedthroughs (30) are electrically connected at a second main surface region (10-2) of the substrate structure (10) to associated second contact elements (20-2) of the further microelectronic component (120), and
**characterized in that** the conductive feedthroughs (30) each comprise, between the first contact element (20-1) and the second contact element (20-2), a layer element (30-1) with a first material with a beta-modification of tungsten, which is superconducting at a quantum computer operating temperature below the transition temperature for the superconductivity, and a filling element (30-2) with a second material, which is electrically conductive above the transition temperature for the superconductivity.

2. Arrangement according to claim 1, wherein the layer element (30-1) constitutes a part of the wall region or the entire wall region of the feedthrough (30), and wherein the filling element (30-2) fills at least 50% of the respective volume of the conductive feedthroughs (30) along the cross section between the first main surface region (10-1) and the second main surface region (10-2) of the substrate structure (10).

3. Arrangement according to claim 1 or 2, wherein the contact elements (20-1; 20-2) are formed as bond bumps or bond pillars.

4. Arrangement according to one of the preceding claims, wherein the contact connection between the contact elements (20-1) of the microelectronic quantum computing component (110) comprises a cryo-compatible connection manufactured by a metal interdiffusion method.

5. Arrangement according to one of the preceding claims, wherein the contact elements (20-1) at the first main surface region (10-1) of the substrate structure (10) comprise connections, manufactured by a metal interdiffusion method, to the contact elements (20-2) of the further microelectronic component (120).

6. Arrangement according to one of the preceding claims, wherein the contact elements (20-1) of the microelectronic quantum computing component (110) are connected to a plurality of conductive feedthroughs (30) in a parallel circuit.

7. Arrangement according to one of the preceding claims, wherein the plurality of conductive feedthroughs (30) are electrically insulated from the substrate structure (10) by means of an insulation material (34).

8. Arrangement according to one of the preceding claims, wherein the filling element (30-2) completely fills the conductive feedthroughs (30) in each case with a tungsten material.

9. Arrangement according to one of the preceding claims, wherein the filling element (30-2) comprises a tungsten material.

10. Arrangement according to claim 9, wherein, in order to maintain the beta-modification of the tungsten of the layer element (30-1), the tungsten is arranged as a layer in the conductive feedthroughs (30) of the substrate (10), wherein, adjacent to the layer element (30-1) with the beta-modification of the tungsten material, a further layer (5; 7) of a further material having a higher coefficient of thermal expansion than the tungsten material is arranged.

11. Arrangement according to claim 9 or 10, wherein, adjacent to the layer element (30-1) with the beta-modification of the tungsten material, a further layer (5; 7) with a further material having a higher coefficient of thermal expansion than the tungsten material is arranged.

12. Arrangement according to claim 11, wherein, adjacent to the layer element (30-1) with the beta-modification of the tungsten material, a further layer (5; 7) with a further material having a higher coefficient of thermal expansion than the tungsten material is arranged in each case on both sides.

13. Method (200) for providing a cryo-compatible quantum computing arrangement, the method comprising:
providing (210) a microelectronic quantum computing component with a substrate structure, a plurality of first contact elements, and a plurality of conductive feedthroughs through the substrate structure, wherein the conductive feedthroughs each comprise a layer element with a first material with a beta-modification of tungsten, which is superconducting at a quantum computer operating temperature below the transition temperature of the superconductivity, and a filling element with a second material, which is electrically conductive above the transition temperature of the superconductivity,
configuring (220) an electrical connection between the conductive feedthroughs at a first main surface region of the substrate structure and the associated first contact elements of the microelectronic quantum computing component,
providing (230) a further microelectronic component with a plurality of second contact elements, and
configuring (240) a further electrical connection at a second main surface region of the substrate structure between the conductive feedthroughs with associated second contact elements and the further microelectronic component.

14. Method according to claim 13, wherein the step (210) of providing the conductive feedthroughs comprises the following substeps:
applying (250) the tungsten material of the layer element under compressive stress in feedthroughs in order to achieve the beta-modification of the tungsten material; and
at least partially or completely filling (260) the feedthroughs with a tungsten material in order to obtain the conductive feedthroughs.

15. Method according to claim 14, further comprising:
arranging (270), adjacent to the layer element with the beta-modification of the tungsten material, a further layer with a material having a higher coefficient of thermal expansion than the tungsten material.

16. Method according to claim 14 or 15, further comprising:
arranging (280), adjacent to the layer element with the beta-modification of the tungsten material, a further layer with a material having a higher coefficient of thermal expansion than the tungsten material in each case on both sides.

## Revendications

1. Aménagement de calcul quantique cryo-compatible (100), aux caractéristiques suivantes:
un composant de calcul quantique microélectronique (110) avec
une structure de substrat (10),
une pluralité de premiers éléments de contact (20-1), et
une pluralité de passages conducteurs (30) à travers la structure de substrat (10),
dans lequel les passages conducteurs (30) sur une première zone de surface principale (10-1) de la structure de substrat (10) sont connectés électriquement aux premiers éléments de contact associés (20-1) du composant de calcul quantique microélectronique (110), et
un autre composant microélectronique (120) avec une pluralité de deuxièmes éléments de contact (20-2),
dans lequel, sur une deuxième zone de surface principale (10-2) de la structure de substrat (10), les passages conducteurs (30) sont connectés électriquement aux deuxièmes éléments de contact associés (20-2) de l'autre composant microélectronique (120), et
**caractérisé par le fait que**
les passages conducteurs (30) présentent, chacun, entre le premier élément de contact (20-1) et le deuxième élément de contact (20-2), un élément de couche (30-1) avec un premier matériau avec une modification bêta du tungstène, qui est supraconducteur à une température de fonctionnement de l'ordinateur quantique au-dessous de la température de saut pour la supraconductivité, et un élément de remplissage (30-2) avec un deuxième matériau qui est électriquement conducteur au-dessus de la température de saut pour la supraconductivité.

2. Aménagement selon la revendication 1, dans lequel l'élément de couche (30-1) représente une partie de la zone de paroi ou la totalité de la zone de paroi du passage (30), et dans lequel l'élément de remplissage (30-2) représente au moins 50% du volume respectif des passages conducteurs (30) le long de la section transversale entre la première zone de surface principale (10-1) et la deuxième zone de surface principale (10-2) de la structure de substrat (10).

3. Aménagement selon la revendication 1 ou 2, dans lequel les éléments de contact (20-1; 20-2) sont conçus sous forme de bosses de liaison ou de piliers de liaison.

4. Aménagement selon l'une des revendications précédentes, dans lequel la connexion de contact entre les éléments de contact (20-1) du composant de calcul quantique microélectronique (110) présente une connexion cryo-compatible réalisée par un procédé d'inter-diffusion métallique.

5. Aménagement selon l'une des revendications précédentes, dans lequel les éléments de contact (20-1) présentent, sur la première zone de surface principale (10-1) de la structure de substrat (10) avec les éléments de contact (20-2) de l'autre composant microélectronique (120), des connexions réalisées par un procédé d'inter-diffusion métallique.

6. Aménagement selon l'une des revendications précédentes, dans lequel les éléments de contact (20-1) du composant de calcul quantique microélectronique (110) sont connectés à une pluralité de passages conducteurs (30) dans un circuit parallèle.

7. Aménagement selon l'une des revendications précédentes, dans lequel la pluralité de passages conducteurs (30) sont isolés électriquement, au moyen d'un matériau isolant (34), de la structure de substrat (10).

8. Aménagement selon l'une des revendications précédentes, dans lequel l'élément de remplissage (30-2) remplit complètement chacun des passages conducteurs (30) par un matériau en tungstène.

9. Aménagement selon l'une des revendications précédentes, dans lequel l'élément de remplissage (30-2) présente un matériau en tungstène.

10. Aménagement selon la revendication 9, dans lequel, pour obtenir la modification bêta du tungstène de l'élément de couche (30-1), le tungstène est disposé en forme de couche dans les passages conducteurs (30) du substrat (10), dans lequel est disposée, de manière adjacente à l'élément de couche (30-1) avec la modification bêta du matériau en tungstène, une autre couche (5; 7) d'un autre matériau qui présente un coefficient de dilatation thermique plus élevé que le matériau en tungstène.

11. Aménagement selon la revendication 9 ou 10, dans lequel est disposée, de manière adjacente à l'élément de couche (30-1) avec la modification bêta du matériau de tungstène, une autre couche (5; 7) avec un autre matériau qui présente un coefficient de dilatation thermique plus élevé que le matériau en tungstène.

12. Aménagement selon la revendication 11, dans lequel est disposée, de manière adjacente à l'élément de couche (30-1) avec la modification bêta du matériau de tungstène, chaque fois des deux côtés, une autre couche (5; 7) avec un autre matériau qui présente chaque fois un coefficient de dilatation thermique plus élevé que le matériau en tungstène.

13. Procédé (200) permettant de mettre à disposition un aménagement de calcul quantique cryo-compatible, dans lequel le procédé présente le fait de:
prévoir (210) un composant de calcul quantique microélectronique avec une structure de substrat, une pluralité de premiers éléments de contact et une pluralité de passages conducteurs à travers la structure de substrat, où les passages conducteurs présentent, chacun, un élément de couche avec un premier matériau avec une modification bêta du tungstène, qui est supraconducteur à une température de fonctionnement de l'ordinateur quantique inférieure à la température de saut de supraconductivité, et un élément de remplissage avec un deuxième matériau, qui est électriquement conducteur au-dessus la température de saut de la supraconductivité,
former (220) une connexion électrique entre les passages conducteurs sur une première zone de surface principale de la structure du substrat et les premiers éléments de contact associés du composant de calcul quantique microélectronique,
prévoir (230) un autre composant microélectronique avec une pluralité de deuxièmes éléments de contact, et
former (240) une autre connexion électrique sur une deuxième zone de surface principale de la structure de substrat entre les passages conducteurs avec les deuxièmes éléments de contact associés et l'autre composant microélectronique.

14. Procédé selon la revendication 13, dans lequel l'étape (210) de la prévision des passages conducteurs présente les sous-étapes suivantes consistant à:
appliquer (250) le matériau de tungstène de l'élément de couche sous contrainte de compression dans les passages pour obtenir la modification bêta du matériau de tungstène; et
remplir au moins partiellement ou complètement (260) les passages par un matériau en tungstène pour obtenir les passages conducteurs.

15. Procédé selon la revendication 14, par ailleurs avec l'étape suivante consistant à:
disposer (270) une autre couche avec un matériau qui présente un coefficient de dilatation thermique plus élevé que le matériau en tungstène, de manière adjacente à l'élément de couche avec la modification bêta du matériau en tungstène.

16. Procédé selon la revendication 14 ou 15, par ailleurs avec l'étape suivante consistant à:
disposer (280), chaque fois des deux côtés, une autre couche avec un matériau qui présente un coefficient de dilatation thermique plus élevé que le matériau en tungstène, de manière adjacente à l'élément de couche avec la modification bêta du matériau en tungstène.
